# EUROPÄISCHE PATENTSCHRIFT

(11) **EP 2 599 370 B1**
(45) Veröffentlichungstag und Bekanntmachung des Hinweises auf die Patenterteilung: **26.10.2016**
(21) Anmeldenummer: 11722006.1
(22) Anmeldetag: 17.05.2011
(51) Int. Cl.: H05K 7/20, H01G 11/10, H01G 11/18, H01G 11/78, H01G 2/06, H01M 10/6551

(54) **ANORDNUNG UND ENERGIESPEICHER MIT EINER ANORDNUNG ZUM TEMPERIEREN, INSBESONDERE KÜHLEN, VON WÄRMEERZEUGENDEN BAUELEMENTEN**
ARRANGEMENT AND ENERGY STORE COMPRISING AN ARRANGEMENT FOR REGULATING THE TEMPERATURE OF, MORE PARTICULARLY COOLING, HEAT-GENERATING COMPONENTS
AGENCEMENT ET ACCUMULATEUR D'ÉNERGIE COMPORTANT UN AGENCEMENT DESTINÉ À TEMPÉRER, EN PARTICULIER À REFROIDIR, DES COMPOSANTS PRODUISANT DE LA CHALEUR

(30) Priorität: 26.07.2010 DE 102010032297
(43) Veröffentlichungstag der Anmeldung: 05.06.2013
(73) Patentinhaber: Sew-Eurodrive GmbH & Co. KG, 76646 Bruchsal (DE)
(72) Erfinder: HAUCK, Matthias, 68723 Schwetzingen (DE); KNIEJSKI, Adrian, 75203 Königsbach-Stein (DE); DEGEN, Dirk, 76646 Bruchsal (DE)
(86) Internationale Anmeldenummer: PCT/EP2011/002434
(87) Internationale Veröffentlichungsnummer: WO 2012/013254

(56) Entgegenhaltungen:
- JP-A- 2004 356 525
- JP-A- 2008 053 635

## Beschreibung

Die Erfindung betrifft eine Anordnung und ein Energiespeicher mit einer Anordnung zum Temperieren, insbesondere Kühlen, von wärmeerzeugenden Bauelementen

Es ist bekannt, dass Kondensatoren elektrische Energie zuführbar ist, wobei die Kondensatoren als Energiespeicher einsetzbar sind.

Aus der JP 2008 053635 A ist eine elektrische Anordnung bekannt, bei der ein Kondensator auf einem Substrat montiert ist und mittels eines Wärme leitenden Elements mit einem Kühlkörper verbunden ist.

Aus der JP 2004 356525 A ist die Entwärmung eines von einem Gehäuse geschützten elektronischen Substrats bekannt.

Der Erfindung liegt daher die Aufgabe zugrunde, den Umweltschutz zu verbessern, insbesondere indem ein Energiespeicher möglichst kompakt weitergebildet wird.

Erfindungsgemäß wird die Aufgabe bei der Anordnung nach den in Anspruch 1 und Anspruch 2 und bei dem Energiespeicher nach den in Anspruch 13 angegebenen Merkmalen gelöst.

Wichtige Merkmale der Erfindung bei der Anordnung zum Temperieren, insbesondere Kühlen, von wärmeerzeugenden Bauelementen, sind, dass sie zumindest einen Kühlkörper mit ausgeprägten Kühlabschnitten, insbesondere Kühlfingern und/oder Kühlrippen, und eine mit den wärmeerzeugenden Bauelementen bestückte Leiterplatte aufweist,

insbesondere wobei die Leiterplatte mit den Bauelementen einseitig bestückt ist, wobei die Leiterplatte Ausnehmungen aufweist, durch welche die Kühlabschnitte des Kühlkörpers hindurchragen in jeweilige Raumbereiche zwischen den Bauelementen.

Von Vorteil ist dabei, dass eine verbesserte Wärmeabfuhr aus den zwischen den Bauelementen angeordneten Zwischenraumbereichen ermöglicht ist. Somit ist die Anordnung leistungsfähiger und kompakter ausführbar. Hierdurch ist insgesamt ein geringerer Materialeinsatz bei gleichem Leistungsvermögen ermöglicht. Dadurch ist auch der Umweltschutz verbessert. Der Kühlkörper ist dabei auf der von den Bauelementen abgewandten Seite der Leiterplatte anordenbar. Somit ist quasi ein Schichtaufbau realisierbar, wobei eine erste Schicht der Kühlkörper, eine zweite Schicht die Leiterplatte und eine dritte Schicht die Bauelementeanordnung ist. Der schichtartige Aufbau wird durchbrochen von den Kühlabschnitten, insbesondere Kühlfingern beziehungsweise Kühlrippen, des Kühlkörpers, indem diese durch die Leiterplattenschicht hindurchragen in die Zwischenraumbereiche zu deren Entwärmung. Die Ausnehmungen in der Leiterplatte reduzieren ebenso den Materialeinsatz und verbessern auf diese Weise auch den Umweltschutz.

Bei einer vorteilhaften Ausgestaltung sind die Bauelemente Kondensatoren, insbesondere Doppelschichtkondensatoren und/oder polare Kondensatoren, wie Elektrolytkondensatoren. Von Vorteil ist dabei, dass diese Bauelemente an ihrer Außenseite metallisch ausführbar sind. Diese Außenseite darf auch auf einem vom Massenpotential unterschiedlichen elektrischen Potential betrieben werden. Denn das Aufnahmeteil ist aus einem elektrisch isolierenden Material fertigbar und trägt somit zur elektrischen Isolation bei. Darüber hinaus ist mittels einer metallischen Außenoberfläche ein gut wärme leitender Übergang vom Bauelement zum Aufnahmeteil erreichbar.

Bei einer vorteilhaften Ausgestaltung sind die Bauelemente flächig angeordnet, insbesondere eben. Von Vorteil ist dabei, dass eine Anordnung und Befestigung auf der Leiterplatte ermöglicht ist. Somit ist eine besonders einfache Herstellung ausführbar.

Erfindungsgemäß bilden die Bauelemente eine regelmäßige ebene Anordnung, insbesondere in einer Gitterstruktur. Von Vorteil ist dabei, dass die Kühlabschnitte des Kühlkörpers ebenso regelmäßig ausbildbar sind und somit wiederum eine einfache Herstellung ermöglicht ist.

Bei einer vorteilhaften Ausgestaltung sind die Bauelemente in Form eines Rechteckgitters, Dreieckgitters oder Quadratgitters angeordnet. Von Vorteil ist dabei, dass eine möglichst gute Ausnutzung des Bauraums ermöglicht ist, also eine möglichst kompakte Ausführung der Anordnung.

Erfindungsgemäß ist zwischen Kühlkörper und Leiterplatte ein Isoliermittel angeordnet, welches den Ausnehmungen der Leiterplatte entsprechende Ausnehmungen aufweist zur Durchführung der Kühlabschnitte,

insbesondere wobei das Isoliermittel elektrisch isolierend wirkt, insbesondere eine höhere elektrische Isolationsfestigkeit und/oder Durchschlagfestigkeit aufweist als Luft,
insbesondere wobei jede Ausnehmung des Isoliermittels mit einer jeweiligen Ausnehmung der Leiterplatte in Deckung bringbar ist. Von Vorteil ist dabei, dass ein Isoliermittel die Durchschlagfestigkeit verbessert und somit kleiner Abstände als die vergleichbar notwendigen Luftabstände einsetzbar sind, also eine kompakte Ausführung ermöglicht ist. Die Ausnehmungen im Isoliermittel reduzieren ebenso den Materialeinsatz und verbessern auf diese Weise auch den Umweltschutz. Bei Fertigung der Ausnehmungen mittels Ausstanzung sind die ausgestanzten Bereiche recyclebar. Bei alternativer Fertigung als Kunststoffspritzgussteil ist kein Verlust an Material beim Herstellen vorhanden. Außerdem ist das Isoliermittel mit gewellter Oberfläche ausführbar, so dass der Oberfläche des Isoliermittels folgende Kriechstrecken vergrößert und somit verbesserte Isolation erreichbar ist.

Bei einer erfindungsgemäßen Ausgestaltung weist das Isoliermittel eine geringere Wärmeleitfähigkeit als Luft auf, insbesondere ist es also als Wärmesperre verwendbar. Von Vorteil ist dabei, dass die Wärme aus den Zwischenraumbereichen abführbar ist an den Kühlkörper und trotz einer kompakten Ausführung des Kühlkörpers, also mit geringer Wärmekapazität, eine leistungsfähige Entwärmung erreichbar ist. Die Wärmesperre trennt heiße von kalten Gebieten.

Erfindungsgemäß sind die Bauelemente als regelmäßiges zweidimensionales, endliches Gitter angeordnet. Von Vorteil ist dabei, dass eine besonders einfache und kompakte Herstellung ermöglicht ist.

Bei einer vorteilhaften Ausgestaltung ist zumindest ein Gehäuseabschnitt und/oder ein Gehäuseteil jedes Bauelements rund, insbesondere zylindrisch, ausgeformt. Von Vorteil ist dabei, dass trotz Berührung oder beinahe Berührung der direkt benachbarten Bauelemente die Zwischenräume derart groß auslegbar sind, dass genügend große Kühlabschnitte hineinreichen zur Wärmeabfuhr.

Bei einer vorteilhaften Ausgestaltung ist die Projektion eines Gehäuseabschnitts oder Gehäuseteils jedes Bauelements in die Leiterplattenebene rund, insbesondere kreisförmig. Von Vorteil ist dabei wiederum, dass eine hohe Leistungsdichte erreichbar ist.

Bei einer vorteilhaften Ausgestaltung ist die Leiterplatte mit anderen Bauelementen beidseitig bestückt. Von Vorteil ist dabei, dass nicht nur ein Energiespeicher aus den Bauelementen sondern auch die Steuerung des Energieflusses und/oder die Überwachung der Bauelemente auf korrekte Funktion ausführbar ist.

Erfindungsgemäß sind Leiterplatte und Kühlkörper schraubverbunden. Von Vorteil ist dabei, dass eine einfache Herstellung erreichbar ist, wobei Leiterplatte und Kühlkörper zueinander zentrierbar sind mittels der Schraubverbindung. Somit sind die erlaubten Abstände zwischen Kühlkörper und Bauelementen beziehungsweise Leiterplatte definiert einhaltbar.

Bei einer vorteilhaften Ausgestaltung sind der Kühlkörper und/oder die Gehäuseabschnitte beziehungsweise Gehäuseteile aus Aluminium. Von Vorteil ist dabei, dass eine gute Wärmeleitfähigkeit erreichbar ist.

Wichtige Merkmale bei dem Energiespeicher mit einer vorgenannten Anordnung sind, dass die Bauelemente Energiespeicher sind, insbesondere zum Speichern von ihnen zugeführter elektrischer Energie geeignet ausgeführt sind. Von Vorteil ist dabei, dass eine hohe Energiedichte im Energiespeicher bei geringer Gesamtmasse erreichbar ist und/oder ein hoher Energiefluss beim Beladen oder Entladen des Energiespeichers zulässig ist.

Weitere Vorteile ergeben sich aus den Unteransprüchen.

Die Erfindung wird nun anhand von Abbildungen näher erläutert:

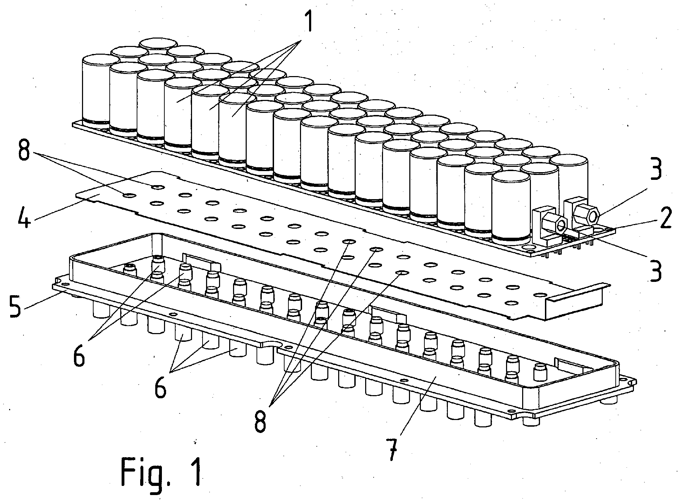

In der Figur 1 ist die erfindungsgemäße Anordnung in Schrägansicht gezeigt, wobei eine Explosionsdarstellung verwendet ist.

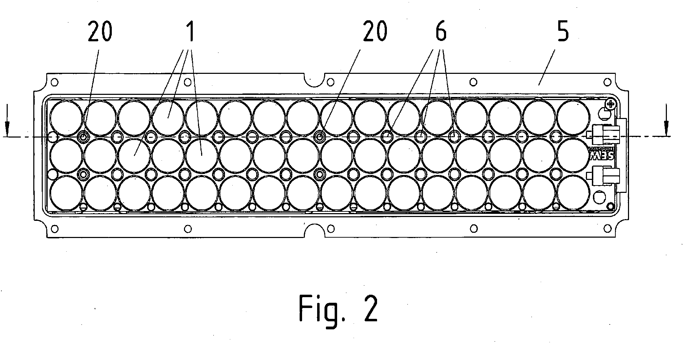

In der Figur 2 ist eine Draufsicht hierzu gezeigt.

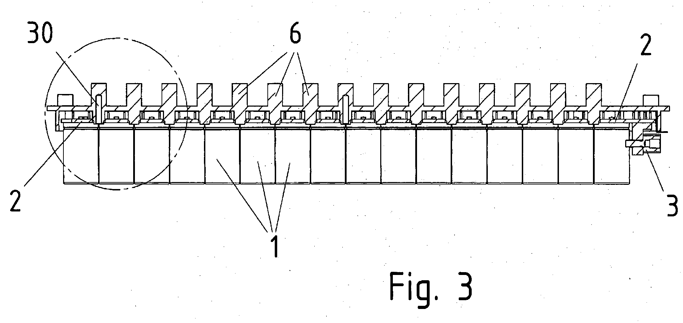

In der Figur 3 ist eine Schnittansicht hierzu gezeigt.

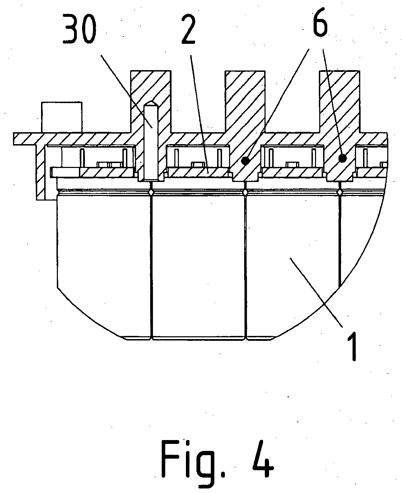

In der Figur 4 ist ein vergrößerter Ausschnitt der Figur 3 gezeigt.

Die Anordnung weist eine Vielzahl von Kondensatoren auf, die auf einer Leiterplatte 2 lötverbunden sind. Dabei bilden die Kondensatoren eine flächige Anordnung, insbesondere ein quadratisches oder Rechteck-Muster. Entsprechend der Anordnung der Kondensatoren sind auch deren Kondensatorgehäuse 1 angeordnet.

Das Kondensatorgehäuseteil 1 ist vorzugsweise aus Metall und weist eine Potentialdifferenz zur elektrischen Masse, also Erde, auf, insbesondere bis zu 500 Volt oder mehr. Als Metall ist vorzugsweise Aluminium verwendet.

Die Anschlüsse der Kondensatoren sind mit metallischen Leiterbahnen der Leiterplatte 2 elektrisch verbunden.

Wegen der flächigen, also ebenen Anordnung der Kondensatoren und deren rundem Gehäuse 1 sind zwischen den Kondensatoren Raumbereiche vorhanden, in die Kühlfinger 6 eines Kühlkörpers hineinragen.

Dabei ist der Kühlkörper an seiner der flächigen Anordnung von Kondensatoren zugewandten Seite wannenartig ausgebildet, so dass Vergussmasse aufnehmbar ist von der Wanne. Dabei ist die Wanne aus einer Grundplatte 5 des Kühlkörpers und einem Rahmen 7 gebildet. Vorzugsweise ist die Wanne samt Grundplatte 5 und Rahmen 7 in einstückiger Weise, beispielsweise als Aluminium-Druckgussteil, gebildet. Ebenfalls einstückig sind dabei Kühlfinger 6 ausgebildet. An ihrem einen Endbereich fließt die Wärme an die Umgebung ab, insbesondere an die umgebende Luft. Im Gegensatz zu alternativ vorsehbaren Kühlrippen ermöglichen die Kühlfinger somit eine von der Einbaulage unabhängige, also isotrope, Wärmeabfuhr.

In der Wanne ist auch die Leiterplatte 2 aufgenommen, auf der die Kondensatoren angeordnet sind, insbesondere auf der der Wanne abgewandten Seite der Leiterplatte 2.

Ein Isoliermittel 4 ist zwischen Leiterplatte 2 und Grundplatte 5 des Kühlkörpers angeordnet. Somit ist eine hohe elektrische Isolationsfestigkeit erreicht.

Die Kühlfinger 6 des Kühlkörpers ragen durch Ausnehmungen 8 des Isoliermittels 4 hindurch sowie auch durch Ausnehmungen der Leiterplatte 2. Die Endbereiche der Kühlfinger ragen in die zwischen den Kondensatorgehäuseteilen gebildeten Raumbereiche hinein.

Der Luftabstand zwischen den Kühlfingern 6 und den Kondensatorgehäuseteilen 1 ist derart groß gewählt, dass kein elektrischer Durchschlag auftreten kann.

Darüber hinaus wird die Wanne bei Herstellung mit Vergussmasse vergossen und somit wird eine noch höhere Isolationsfestigkeit erreicht. Denn die Isolationsfestigkeit der Vergussmasse ist höher als die der Luft.

Auf der Leiterplatte 2 sind auch Anschlussvorrichtungen 3 angeordnet zum elektrischen Anschluss.

Mittels in Gewindebohrungen 30 eingeschraubten Verbindungsschrauben 20 ist die Leiterplatte 2 mit dem Kühlkörper verbunden.

Der Kühlkörper weist an seiner Außenseite Kühlfinger auf.

Da die Kühlfinger der Innenseite des Kühlkörpers in die Raumbereiche zumindest teilweise eindringen und somit Vergussmasse wärmeleitend zwischen Kühlfinger und Gehäuseteilen 1 angeordnet ist, ist Wärme aus dem Inneren der Anordnung der Kondensatoren einfach und schnell abtransportierbar, insbesondere passiv.

Mittels der sich in die Raumbereiche erstreckenden Kühlfinger 6 ist eine direkte Herausführung der Wärme aus den Zwischenräumen zwischen den Gehäuseteilen 1 ermöglicht, welche als Wärmequellen fungieren.

Die Kondensatoren sind auf der Leiterplatte 2 angeordnet, wobei die Anschlussfüsschen der Kondensatoren durch kleine Bohrlöcher der Leiterplatte hindurchgeführt sind und auf der von den Kondensatoren abgewandten Seite der Leiterplatte 2 lötverbunden sind mit Leiterbahnen der Leiterplatte 2.

Die Ausnehmungen in der Leiterplatte 2 dienen nicht nur zum Durchführen der Kühlfinger des Kühlkörpers sondern auch zum Zentrieren des Kühlkörpers. Nach dem Zentrieren wird die Verbindung mittels Verschraubung ausgeführt.

In einem weiteren erfindungsgemäßen Ausführungsbeispiel weist der Kühlkörper zumindest an seiner Außenseite Kühlrippen statt der Kühlfinger auf.

### Bezugszeichenliste

- 1: Kondensatorgehäuseteil
- 2: Leiterplatte
- 3: Anschlussvorrichtungen
- 4: Isoliermittel
- 5: Grundplatte
- 6: Kühlfinger
- 7: Rahmen zur Bildung einer Wanne, umfassend Grundplatte 5
- 8: Ausnehmungen
- 20: Verbindungsschraube
- 30: Gewindebohrung

## Patentansprüche

1. Anordnung zum Temperieren, insbesondere Kühlen, von wärmeerzeugenden Bauelementen,
aufweisend zumindest einen Kühlkörper (5,7) mit ausgeprägten Kühlabschnitten (6) in Form von Kühlfingern und/oder Kühlrippen, und eine mit den wärmeerzeugenden Bauelementen (1) bestückte Leiterplatte (2),
wobei die Leiterplatte mit den Bauelementen zumindest einseitig bestückt ist,
wobei die Leiterplatte Ausnehmungen aufweist, durch welche die Kühlabschnitte des Kühlkörpers hindurchragen in jeweilige Raumbereiche zwischen den Bauelementen,
wobei die Bauelemente eine regelmäßige ebene Anordnung bilden, wobei die Bauelemente und Kühlabschnitte jeweils als regelmäßiges zweidimensionales, endliches Gitter angeordnet sind, wobei die Gitterkonstanten der Gitter der Bauelemente und der Kühlabschnitte gleich sind,
wobei zwischen Kühlkörper und Leiterplatte ein Isoliermittel (4) angeordnet ist, welches den Ausnehmungen der Leiterplatte entsprechende Ausnehmungen (8) aufweist zur Durchführung der Kühlabschnitte,
wobei das Isoliermittel eine geringere Wärmeleitfähigkeit als Luft aufweist, also als Wärmesperre verwendet ist,
wobei Leiterplatte und Kühlkörper schraubverbunden (20,30) sind.

2. Anordnung zum Temperieren, insbesondere Kühlen, von wärmeerzeugenden Bauelementen,
aufweisend zumindest einen Kühlkörper (5,7) mit ausgeprägten Kühlabschnitten (6) in Form von Kühlfingern und/oder Kühlrippen, und eine mit den wärmeerzeugenden Bauelementen (1) bestückte Leiterplatte (2),
wobei die Leiterplatte mit den Bauelementen zumindest einseitig bestückt ist,
wobei die Leiterplatte Ausnehmungen aufweist, durch welche die Kühlabschnitte des Kühlkörpers hindurchragen in jeweilige Raumbereiche zwischen den Bauelementen,
wobei die Bauelemente eine regelmäßige ebene Anordnung bilden, wobei die Bauelemente und Kühlabschnitte jeweils als regelmäßiges zweidimensionales, endliches Gitter angeordnet sind, wobei die Gitterkonstanten der Gitter der Bauelemente und der Kühlabschnitte gleich sind,
wobei zwischen Kühlkörper und Leiterplatte ein Isoliermittel (4) angeordnet ist, welches den Ausnehmungen der Leiterplatte entsprechende Ausnehmungen (8) aufweist zur Durchführung der Kühlabschnitte,
wobei das Isoliermittel eine höhere Wärmeleitfähigkeit als Luft aufweist, also die Wärmeableitung an den Kühlkörper verbessert,
wobei Leiterplatte und Kühlkörper schraubverbunder (20,30) sind.

3. Anordnung nach Anspruch 1,
**dadurch gekennzeichnet, dass**
die Bauelemente Kondensatoren, insbesondere Doppelschichtkondensatoren und/oder polare Kondensatoren, wie Elektrolytkondensatoren, sind.

4. Anordnung nach mindestens einem der vorangegangenen Ansprüche,
**dadurch gekennzeichnet, dass**
die Bauelemente flächig angeordnet sind, also in einer Ebene, also durch gedachte, in der Ebene liegende Transversalverschiebungen ineinander übergehen.

5. Anordnung nach mindestens einem der vorangegangenen Ansprüche,
**dadurch gekennzeichnet, dass**
die Bauelemente eine regelmäßige ebene Anordnung in einer Gitterstruktur, insbesondere in einer ebenen Gitterstruktur bilden.

6. Anordnung nach mindestens einem der vorangegangenen Ansprüche,
**dadurch gekennzeichnet, dass**
die Bauelemente in Form eines Rechteckgitters, Dreieckgitters oder Quadratgitters angeordnet sind.

7. Anordnung nach mindestens einem der vorangegangenen Ansprüche,
**dadurch gekennzeichnet, dass**
das Isoliermittel elektrisch isolierend wirkt, insbesondere eine höhere elektrische Isolationsfestigkeit und/oder Durchschlagfestigkeit aufweist als Luft,
insbesondere wobei jede Ausnehmung des Isoliermittels mit einer jeweiligen Ausnehmung der Leiterplatte in Deckung bringbar ist.

8. Anordnung nach mindestens einem der vorangegangenen Ansprüche,
**dadurch gekennzeichnet, dass**
zumindest ein Gehäuseabschnitt und/oder ein Gehäuseteil jedes Bauelements rund, insbesondere zylindrisch, ausgeformt ist,
insbesondere wobei die Projektion eines Gehäuseabschnitts oder Gehäuseteils jedes Bauelements in die Leiterplattenebene rund, insbesondere kreisförmig, ist.

9. Anordnung nach mindestens einem der vorangegangenen Ansprüche,
**dadurch gekennzeichnet, dass**
die Leiterplatte mit anderen Bauelementen beidseitig bestückt ist.

10. Anordnung nach mindestens einem der vorangegangenen Ansprüche,
**dadurch gekennzeichnet, dass**
der Kühlkörper und/oder die Gehäuseabschnitte beziehungsweise Gehäuseteile aus Aluminium sind.

11. Anordnung nach mindestens einem der vorangegangenen Ansprüche,
**dadurch gekennzeichnet, dass**
der Kühlkörper, insbesondere eine Grundplatte (5) des Kühlkörpers, an welcher die Kühlabschnitte ausgeprägt sind, auf eine Wärmesenke montiert ist oder die Kühlabschnitte mit ihrem von den Bauelementen abgewandten Endbereich nach außen, also in-die Umgebung, weisend angeordnet sind.

12. Anordnung nach mindestens einem der vorangegangenen Ansprüche,
**dadurch gekennzeichnet, dass**
zumindest zwischen den Bauelementen und den Kühlabschnitten Vergussmasse angeordnet ist, insbesondere also in den Raumbereichen zwischen den Bauelementen, insbesondere zur Verbesserung des Wärmeübergangs von den Bauelementen in die Kühlfinger, zur Erhöhung der elektrischen Isolationsfestigkeit und zur Verbesserung der mechanischen Stabilität und Beständigkeit.

13. Energiespeichermodul mit einer Anordnung zum Temperieren, insbesondere Kühlen, von wärmeerzeugenden Bauelementen,
aufweisend zumindest einen Kühlkörper mit ausgeprägten Kühlabschnitten, insbesondere Kühlfingern und/oder Kühlrippen, und eine mit den wärmeerzeugenden Bauelementen bestückte Leiterplatte,
wobei die Leiterplatte mit den Bauelementen zumindest einseitig bestückt ist,
wobei die Leiterplatte Ausnehmungen aufweist, durch welche die Kühlabschnitte des Kühlkörpers hindurchragen in jeweilige Raumbereiche zwischen den Bauelementen,
wobei die Bauelemente eine regelmäßige ebene Anordnung bilden, wobei die Bauelemente und Kühlabschnitte jeweils als regelmäßiges zweidimensionales, endliches Gitter angeordnet sind, wobei die Gitterkonstanten der Gitter der Bauelemente und der Kühlabschnitte gleich sind,
wobei zwischen Kühlkörper und Leiterplatte ein Isoliermittel angeordnet ist, welches den Ausnehmungen der Leiterplatte entsprechende Ausnehmungen aufweist zur Durchführung der Kühlabschnitte,
wobei die Kühlabschnitte in das Energiespeichermodul weisen,
wobei die Bauelemente Energiespeicher sind, insbesondere zum Speichern von ihnen zugeführter elektrischer Energie geeignet ausgeführt sind,
wobei das Energiespeichermodul ein Gehäuse aufweist, in welches eine oder mehrere Anordnungen nach einem der Ansprüche 1 bis 11 eingebaut oder einmontiert ist beziehungsweise sind.

## Claims

1. Arrangement for regulating the temperature of, in particular cooling, heat-generating components,
comprising at least one cooling body (5, 7) having prominent cooling sections (6) in the form of cooling fingers and/or cooling ribs, and a printed circuit board (2) populated with the heat-generating components (1),
wherein the printed circuit board is populated with the components (1) on at least one side,
wherein the printed circuit board has cutouts through which the cooling sections of the cooling body project into respective spatial regions between the components,
wherein the components form a regular plane arrangement, wherein the components and cooling sections are arranged respectively as a regular two-dimensional, finite grid, wherein the grid constants of the grids of the components and of the cooling sections are equal,
wherein an insulating material (4) is arranged between cooling body and printed circuit board, which material has cutouts (8), corresponding to the cutouts of the printed circuit board, for leading the cooling sections through,
wherein the insulating material has a lower thermal conductivity than air, i.e. is used as a thermal barrier,
wherein printed circuit board and cooling body are screw-connected (20, 30).

2. Arrangement for regulating the temperature of, in particular cooling, heat-generating components,
comprising at least one cooling body (5, 7) having prominent cooling sections (6) in the form of cooling fingers and/or cooling ribs, and a printed circuit board (2) populated with the heat-generating components (1),
wherein the printed circuit board is populated with the components on at least one side,
wherein the printed circuit board has cutouts through which the cooling sections of the cooling body project into respective spatial regions between the components,
wherein the components form a regular plane arrangement, wherein the components and cooling sections are arranged respectively as a regular two-dimensional, finite grid, wherein the grid constants of the grids of the components and of the cooling sections are equal,
wherein an insulating material (4) is arranged between cooling body and printed circuit board, which material has cutouts (8), corresponding to the cutouts of the printed circuit board, for leading the cooling sections through,
wherein the insulating material has a higher thermal conductivity than air, i.e. improves the thermal dissipation to the cooling body,
wherein printed circuit board and cooling body are screw-connected (20, 30).

3. Arrangement according to claim 1,
**characterised in that**
the components are capacitors, in particular double-layer capacitors and/or polar capacitors, such as electrolytic capacitors.

4. Arrangement according to at least one of the preceding claims,
**characterised in that**
the components are arranged in a planar manner, i.e. in a plane, i.e. merge into one another by imaginary transverse displacements lying in the plane.

5. Arrangement according to at least one of the preceding claims,
**characterised in that**
the components form a regular plane arrangement in a grid structure, in particular in a plane grid structure.

6. Arrangement according to at least one of the preceding claims,
**characterised in that**
the components are arranged in the form of a rectangular grid, triangular grid or square grid.

7. Arrangement according to at least one of the preceding claims,
**characterised in that**
the insulating material has an electrically insulating effect, in particular has a higher insulation resistance and/or dielectric strength than air,
in particular wherein each cutout of the insulating material can be brought into coincidence with a respective cutout of the printed circuit board.

8. Arrangement according to at least one of the preceding claims,
**characterised in that**
at least one housing section and/or one housing part of each component is of round, in particular cylindrical, shape,
in particular wherein the projection of a housing section or housing part of each component into the printed circuit board plane is round, in particular circular.

9. Arrangement according to at least one of the preceding claims,
**characterised in that**
the printed circuit board is populated with different components on both sides.

10. Arrangement according to at least one of the preceding claims,
**characterised in that**
the cooling body and/or the housing sections or housing parts are made of aluminium.

11. Arrangement according to at least one of the preceding claims,
**characterised in that**
the cooling body, in particular a base plate (5) of the cooling body on which the cooling sections are prominent, is mounted on a heat sink or the cooling sections are arranged with their end region, which faces away from the components, pointing outwards, i.e. into the surroundings.

12. Arrangement according to at least one of the preceding claims,
**characterised in that**
casting compound is arranged at least between the components and the cooling sections, i.e. in particular in the spatial regions between the components, in particular for improving the heat transfer from the components to the cooling fingers, for increasing the electrical insulation resistance and for improving the mechanical stability and resistance.

13. Energy storage module having an arrangement for regulating the temperature of, in particular cooling, heat-generating components,
comprising at least one cooling body having prominent cooling sections, in particular cooling fingers and/or cooling ribs, and a printed circuit board populated with the heat-generating components,
wherein the printed circuit board is populated with the components on at least one side,
wherein the printed circuit board has cutouts through which the cooling sections of the cooling body project into respective spatial regions between the components,
wherein the components form a regular plane arrangement, wherein the components and cooling sections are arranged respectively as a regular two-dimensional, finite grid, wherein the grid constants of the grids of the components and of the cooling sections are equal,
wherein an insulating material is arranged between cooling body and printed circuit board, which material has cutouts, corresponding to the cutouts of the printed circuit board, for leading the cooling sections through,
wherein the cooling sections point into the energy storage module,
wherein the components are energy stores, in particular are designed for storing electrical energy supplied to them,
wherein the energy storage module has a housing in which one or more arrangements according to one of claims 1 to 11 is or are installed or mounted.

## Revendications

1. Agencement destiné à tempérer, en particulier refroidir, des composants produisant de la chaleur,
comportant au moins un radiateur (5, 7) avec des sections de refroidissement (6) en saillie sous la forme de doigts de refroidissement et/ou d'ailettes de refroidissement, et une carte de circuit imprimé (2) équipée des composants produisant de la chaleur (1),
la carte de circuit imprimé étant équipée des composants au moins d'un côté,
la carte de circuit imprimé comportant des évidements à travers lesquels les sections de refroidissement du radiateur font saillie dans les espaces respectifs entre les composants,
les composants formant un agencement plan régulier, les composants et les sections de refroidissement étant disposés dans chaque cas sous la forme d'un réseau bidimensionnel régulier fini, les constantes de réseau des réseaux des composants et des sections de refroidissement étant identiques,
un isolant (4) étant disposé entre le radiateur et la carte de circuit imprimé, lequel comporte des évidements (8) correspondant aux évidements de la carte de circuit imprimé pour le passage des sections de refroidissement,
l'isolant présentant une conductibilité thermique plus faible que l'air et étant donc utilisé comme barrière thermique,
la carte de circuit imprimé et le radiateur étant reliés par vissage (20, 30).

2. Agencement destiné à tempérer, en particulier refroidir, des composants produisant de la chaleur,
comportant au moins un radiateur (5, 7) avec des sections de refroidissement (6) en saillie sous la forme de doigts de refroidissement et/ou d'ailettes de refroidissement, et une carte de circuit imprimé (2) équipée des composants produisant de la chaleur (1),
la carte de circuit imprimé étant équipée des composants au moins d'un côté,
la carte de circuit imprimé comportant des évidements à travers lesquels les sections de refroidissement du radiateur font saillie dans les espaces respectifs entre les composants,
les composants formant un agencement plan régulier, les composants et les sections de refroidissement étant disposés dans chaque cas sous la forme d'un réseau bidimensionnel régulier fini, les constantes de réseau des réseaux des composants et des sections de refroidissement étant identiques,
un isolant (4) étant disposé entre le radiateur et la carte de circuit imprimé, lequel comporte des évidements (8) correspondant aux évidements de la carte de circuit imprimé pour le passage des sections de refroidissement,
l'isolant présentant une conductibilité thermique plus élevée que l'air et améliorant donc la dissipation de chaleur sur le radiateur,
la carte de circuit imprimé et le radiateur étant reliés par vissage (20, 30).

3. Agencement selon la revendication 1,
**caractérisé en ce que**
les composants sont des condensateurs, en particulier des condensateurs à double couche et/ou des condensateurs polarisés tels que des condensateurs électrolytiques.

4. Agencement selon au moins l'une des revendications précédentes,
**caractérisé en ce que**
les composants sont disposés en nappe, donc dans un plan, donc se succèdent par des déplacements transversaux imaginaires situés dans le plan.

5. Agencement selon au moins l'une des revendications précédentes,
**caractérisé en ce que**
les composants forment un agencement plan régulier dans une structure réticulaire, en particulier dans une structure réticulaire plane.

6. Agencement selon au moins l'une des revendications précédentes,
**caractérisé en ce que**
les composants sont disposés sous la forme d'un réseau rectangulaire, d'un réseau triangulaire ou d'un réseau carré.

7. Agencement selon au moins l'une des revendications précédentes,
**caractérisé en ce que**
l'isolant a un effet isolant électriquement, en particulier présente une capacité d'isolation électrique et/ou une rigidité diélectrique plus élevée que l'air,
en particulier chaque évidement de l'isolant pouvant être mis en coïncidence avec un évidement respectif de la carte de circuit imprimé.

8. Agencement selon au moins l'une des revendications précédentes,
**caractérisé en ce que**
au moins une section de boîtier et/ou une partie de boîtier de chaque composant est de forme ronde, en particulier cylindrique,
en particulier la projection d'une section de boîtier ou d'une partie de boîtier de chaque composant est ronde, en particulier circulaire, dans le plan de la carte de circuit imprimé.

9. Agencement selon au moins l'une des revendications précédentes,
**caractérisé en ce que**
la carte de circuit imprimé est équipée d'autres composants des deux côtés.

10. Agencement selon au moins l'une des revendications précédentes,
**caractérisé en ce que**
le radiateur et/ou les sections de boîtier ou parties de boîtier sont en aluminium.

11. Agencement selon au moins l'une des revendications précédentes,
**caractérisé en ce que**
le radiateur, en particulier une plaque de base (5) du radiateur, sur laquelle les sections de refroidissement sont en saillie, est montée sur un dissipateur de chaleur ou les sections de refroidissement sont disposées de façon à présenter leur zone d'extrémité éloignée des composants vers l'extérieur, donc dans l'environnement.

12. Agencement selon au moins l'une des revendications précédentes,
**caractérisé en ce que**
une masse de scellement est disposée au moins entre les composants et les sections de refroidissement, en particulier donc dans les espaces entre les composants, en particulier pour améliorer le transfert de chaleur des composants dans les doigts de refroidissement, pour augmenter la capacité d'isolation électrique et pour améliorer la stabilité et la résistance mécanique.

13. Module de stockage d'énergie comprenant un agencement destiné à tempérer, en particulier refroidir, des composants produisant de la chaleur,
comportant au moins un radiateur avec des sections de refroidissement en saillie, en particulier des doigts de refroidissement et/ou des ailettes de refroidissement, et une carte de circuit imprimé équipée des composants produisant de la chaleur,
la carte de circuit imprimé étant équipée des composants au moins d'un côté,
la carte de circuit imprimé comportant des évidements à travers lesquels les sections de refroidissement du radiateur font saillie dans les espaces respectifs entre les composants,
les composants formant un agencement plan régulier, les composants et les sections de refroidissement étant disposés dans chaque cas sous la forme d'un réseau bidimensionnel régulier fini, les constantes de réseau des réseaux des composants et des sections de refroidissement étant identiques,
un isolant étant disposé entre le radiateur et la carte de circuit imprimé, lequel comporte des évidements correspondant aux évidements de la carte de circuit imprimé pour le passage des sections de refroidissement,
les sections de refroidissement étant dirigées dans le module de stockage d'énergie,
les composants étant des accumulateurs d'énergie, en particulier adaptés pour stocker une énergie électrique qui leur est amenée,
le module de stockage d'énergie comportant un boîtier dans lequel un ou plusieurs agencements selon au moins l'une des revendications 1 à 11 peut ou peuvent être intégré(s) ou monté(s).
